(19) **Europäisches Patentamt**

**European Patent Office**

**Office européen des brevets**

(11) **EP 0 935 532 B1**

(12) **EUROPEAN PATENT SPECIFICATION**

(45) Date of publication and mention
of the grant of the patent:
**30.11.2005 Bulletin 2005/48**

(51) Int Cl.⁷: **B41F 15/42**, H05K 3/12,
B41M 1/12, B05D 1/32,
B05D 1/26

(21) Application number: **97950016.2**

(22) Date of filing: **13.10.1997**

(86) International application number:
**PCT/EP1997/005761**

(87) International publication number:
**WO 1998/016387 (23.04.1998 Gazette 1998/16)**

(54) **PROCESS AND APPARATUS FOR THE DEPOSITION OF A VISCOUS PRODUCT ON A SUBSTRATE VIA A STENCIL**

VERFAHREN UND VORRICHTUNG ZUR ABLAGERUNG VON EINEM VISKOSEN PRODUKT MIT EINER SCHABLONE

PROCEDE ET APPAREIL DESTINES AU DEPOT D'UN PRODUIT VISQUEUX SUR UN SUBSTRAT VIA UN POCHOIR

(84) Designated Contracting States:
**AT BE CH DE DK ES FI FR GB GR IE IT LI LU MC NL PT SE**

(30) Priority: **15.10.1996 FR 9612671**
**28.01.1997 FR 9701033**

(43) Date of publication of application:
**18.08.1999 Bulletin 1999/33**

(60) Divisional application:
**05001673.2**

(73) Proprietor: **Societe Novatec S.A.**
**82000 Montauban (FR)**

(72) Inventors:
• **BOURRIERES, Francis**
**F-82000 Montauban (FR)**

• **KAISER, Clément**
**F-82000 Montauban (FR)**

(74) Representative: **Boden, Keith McMurray et al**
**Fry Heath & Spence LLP**
**The Gables**
**Massetts Road**
**Horley Surrey RH6 7DQ (GB)**

(56) References cited:
WO-A-96/20088     CH-A- 648 497
DE-A- 2 250 092     GB-A- 1 433 957
US-A- 3 384 931     US-A- 3 656 428
US-A- 3 921 521     US-A- 4 023 486
US-A- 4 622 239     US-A- 4 720 402

**Description**

The present invention relates to a method and device for carrying out the deposition of a viscous product on a substrate through the apertures of a stencil or screen, and may be applied in a screen printing machine.

The substrate can be a printed circuit on which electronic components have to be retained, then soldered. The viscous product can be a non-conductive or conductive adhesive or soldering paste or another silicon type viscous product. The stencil can be a screen printing stencil, either of the traditional type, that is to say a mesh or metallic stencil, or of the type which is the subject-matter of French patent no. 94.08518 of the present applicant, relating to a stencil allowing the deposition and the dosing of the products applied.

The examples of implementation of the invention are all within the area of deposition by screen printing of soldering pastes such as are used in the electronics industry to produce cards by soldering of components onto printed circuits. Nevertheless, the invention can find application in other technical fields.

The soldering pastes are heterogeneous materials, the components of which have different densities. The soldering pastes are composed of metallic materials and organic or flux materials. The mass of the metallic part represents approximately 85% to 90% of the total mass, with a density of 8 to 12 according to the metals used, and in volume terms it represents only approximately 50%. The organic material, also called flux, has a density of almost, or of, 1.

The soldering paste is constituted by metallic microspheres joined by the flux or organic material. This viscous flux comprises rheologic agents, adhesive agents and cleaning agents which affect the method of assembling components on printed circuits taking place in accordance with the following steps:

- deposition by screen printing of soldering paste contacts;
- placing of components on the paste contacts, the adhesive agent of which holds the components;
- reflow of the soldering paste in the furnace, which causes the coalescence of the metallic microspheres.

The function of the alloy constituted by the soldering paste is to provide the supply of metal necessary and strictly sufficient to ensure electrical interconnection between the pins of the components and the printed circuit by soldering. The organic materials in the paste must disappear at the conclusion of the soldering operation. Nevertheless, there is generally a residue which must be cleaned with water or with solvent, which is both costly and polluting.

Soldering pastes supposed to have low residue have been developed. In these pastes, the organic part has substantially the same value in volume terms as in the previous pastes, but the elements providing the different functions desired have a different behaviour. Light solvents with low boiling points are introduced to provide a proper rheology. Because of this, these solvents become volatile more rapidly and almost completely during the pre-heating operation which precedes the reflow step. At the end of the reflow step there thus remains little residue connected with this function. In order to provide a satisfactory adhesive capacity, the light solvents described above are combined with adhesive resins which become volatile or sublimate in the reflow step.

The cleaning agents for preparation of a surface which is suitable and is indispensable for obtaining a satisfactory inter-metal connection occupy a very small part of the total volume of the paste, this being in order to reduce the residue connected with this function. As the overall efficiency of the cleaning must not change, the volume efficiency of the active cleaning constituent has to increase in the same proportions as the total amount of residue diminishes.

The consequence of this research into existing soldering pastes with the least total amount of residue results, on the one hand, in a greater dilution of the active constituents in the paste and, on the other hand, in a greater volatility of the additional solvents used. It is therefore necessary that when the soldering paste is applied to the substrate, an extremely homogeneous distribution of the active constituent is obtained in all the elemental points of the volume of each deposit. If this is not achieved, adjacent or non-adjacent deposits of the solder paste will be obtained in which the efficacy of cleaning, for example, will not be identical. Certain points will be over-activated with a problem of residues and of cleaning, others will be under-activated and the soldering obtained will be of poor quality.

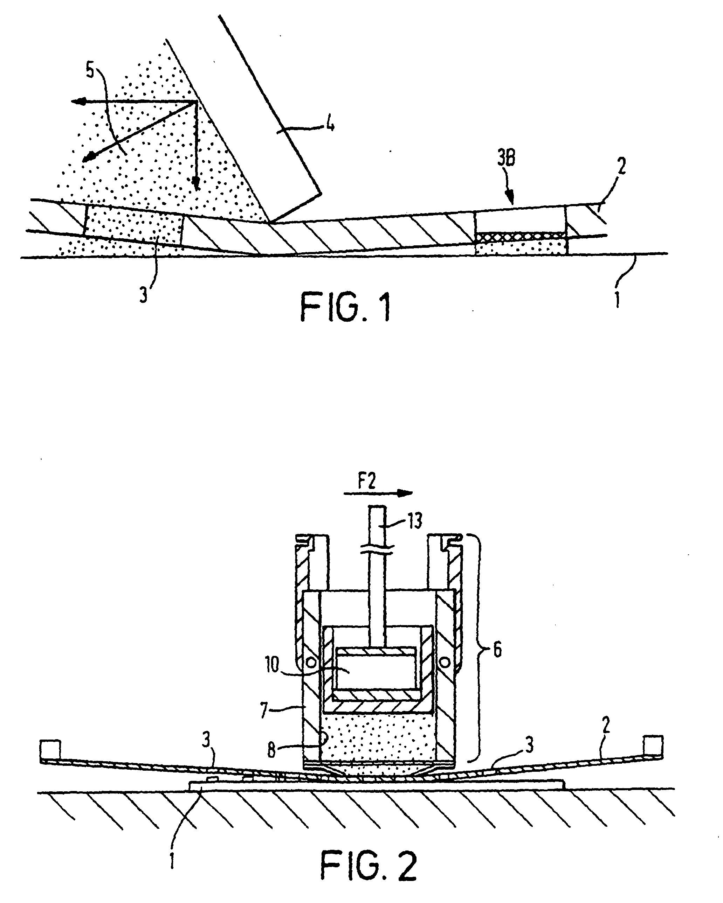

The high degree of solubility of the additional solvents used causes the problem of their evaporation during the operation of producing electronic cards. The fact that with the current modes of deposition the product is dragged by means of an inclined wiper (see Figure 1) in the open air does not allow this phenomenon to be overcome. This results in a change in the rheology of the soldering paste during production, which leads to the parameters for control of the machine being modified or, in extreme cases, to changing the soldering paste which may have become too dry and no longer passes properly through the apertures in the stencil.

Other elements add to this problem when production requirements necessitate high-speed screen printing, for example at 200 millimetres per second as opposed to 20 to 50 millimetres per second. Because of this thixotropic additives are introduced and combine with the other solvents. Evaporation of the base solvents therefore modifies the possible speed of deposition. By way of example, an evaporation of 1 % from the volume of soldering paste completely changes the rheology and makes screen printing very difficult, if not impossible.

Another of the problems caused by the known technology is the control of the wear and tear on the wiper system. Progressive erosion of the active edge of the wiper by rubbing alters the intrinsic qualities of the paste applied, and that of the depositions because of the uncontrolled and random retrieval of a certain quantity of microspheres with each alternate wipe, the wipers being displaced alternately. In fact, the wipers are only changed when the poor quality of the deposition is a noticeable consequence of their wear.

In the known technology, two types of wipers are used:

- A rubber or polyurethane type, the hardness of which varies generally between 70 to 90 Shore. This wiper has the advantage of good deformation by virtue of its low degree of hardness and its flexibility, thus good sealing is produced. It has the inconvenience of deforming during passage over the apertures in the stencil. For apertures where the dimension parallel to the wiper is less than 0.5 mm, this is not a major problem. Where the apertures have dimensions parallel to the wiper greater than this value, the deposit is hollowed out. Where deposits are larger than 3 mm, they are completely dragged off again.

- A metallic type, the advantage of which is to maintain rigidity, which does not allow the deposit to be hollowed out, but the hardness of which, despite its flexibility, does not allow perfect sealing with the stencil to be produced. It hardness sometimes exceeds that of the stencil and because of this there are scratches and encrustation of solder microspheres. The excessive pressure of the metallic wiper can also cause crushing of the tin-lead spheres, this alloy being much softer than the steel wiper.

Until now it did not appear that solutions had been found to eliminate these problems.

WO 96/20088 filed by the FORD MOTOR COMPANY claims a method and a device for distributing a viscous product by compression thereof through the apertures of a stencil. The device comprises a reservoir receiving a charge of viscous product; a pressure is exerted on the viscous material in the reservoir. This is linked via a conduit to a distribution nozzle, with a conical internal shape with baffle plates, and provided with a rectangular distribution slit delimited by two wipers in opposite directions, slightly inclined with respect to the vertical. The two wipers bear against the stencil and keep it in contact with the substrate in the zone between them. The aim of this device is to allow implementation of high-speed screen printing.

It appears that the technology and the means disclosed by this patent not only do not permit the resolution of the problems described previously, but moreover accentuate them. Indeed, the viscous material has to be placed in a reservoir which is an integral part of the system. The viscous material has, following the reservoir, to be pushed under pressure towards the nozzle. The system according to Ford has disadvantages, in particular with regard to the cleaning of the circuit from the reservoir to the compression chamber. Further, the conical internal shape of the nozzle, and the baffle plates with which it is provided, in theory to guide and equalise the pressure, will have the effect of laminating the paste, which is hardly compatible with its heterogenous nature and the difference in density of the metallic parts and of the flux, this lamination creating a significant risk of separating the components and thus of deposits of unequal quality. In addition, according to Ford, the compression chamber bears upon the stencil, elasticity being obtained by the wipers, either under the effect of the pressure independent of that conferred to the product in the compression chamber or under the effect of springs acting on the wipers.

DE-A-2250092 discloses a rotary stencil printing device for depositing a liquid onto a moving substrate. The device includes a housing, which is loaded to maintain contact with the stencil and includes a cavity from which liquid is gravity fed to the substrate.

GB-A-1433957 discloses a stencil printing device for depositing a liquid onto a substrate. The device includes a cavity from which liquid is gravity fed to the substrate.

Embodiments of the present invention provide a method and device for carrying out the deposition of a viscous product on a substrate through the apertures of a stencil or screen which allow the above problems to be solved.

Furthermore, preferred embodiments of the invention propose for screen printers a method and a device containing a viscous product which are directly adaptable, practically without modification, to existing screen printing machines, which allow the product not to be handled in the open air, which avoid changes in the product, and which do not have a distributer to clean.

Furthermore, as will be set out in the description of preferred embodiments to follow, the device may be useable as a consumable distributer, thrown away after the viscous product it contains is used up, providing a solution to the problem of recycling by the suppliers of unused or incompletely used pots of pastes.

Accordingly, the present invention provides the device of claim 1.

The present invention also provides the method of claim 16.

The efficacy of the system in transferring a viscous product through an aperture can be characterised by the following coefficient:

$$K = \frac{\text{contact time (T) x (PT) pressure of transfer}}{\text{(VI) viscosity}}$$

T being the duration for which the product to be transferred is in contact with the aperture.

PT being the pressure to which the product to be transferred is subjected, VI being the viscosity.

K is a non-unitary value which is proportional to the efficacy of the transfer.

The greater the value K, the more easily the product will be transferred.

The following description of preferred embodiments will allow it to be understood that the invention satisfies all the conditions set out hereinabove.

Other advantages and features of the invention will become evident from reading the description hereinafter of preferred embodiments of the invention, given by way of a non-limiting example and illustrated by the attached drawings, in which:

Figure 1 schematically shows an operation of deposition of a viscous product by screen printing according to the prior art;

Figure 2 is a view in transverse section of a device embodying to the invention;

Figure 3 is a view in transverse section of the device according to Figure 2;

Figure 4 is a view in longitudinal section of the device according to Figure 2;

Figure 5 shows, in a transverse section view, the pressures exerted in the device and on the stencil and the substrate;

Figure 6 shows the means of separation between the device and the stencil so that it can be removed;

Figure 7 shows the homogenising grille;

Figure 8 shows the wipers;

Figure 9 shows a view in transverse section of another embodiment of the device according to the invention;

Figure 10 is a view in longitudinal section of a device for the deposition of pasty or viscous product with an intermediate receptacle embodying to the invention.

Figure 11 is a perspective view of the intermediate receptacle with its cover;

Figure 12 is a view in transverse section of the device according to Figure 10;

Figure 13 is a device for mixing the product in an embodiment of the invention.

Figure 1 shows the implementation of making deposits onto a substrate 1 through a stencil or a screen 2 provided with apertures 3, by means of a wiper 4. The product to be applied is labelled 5.

A standard wiper 4 inclined at an angle which can vary from 60° to 45° with respect to the horizontal fulfils several functions at the same time:

- it drags the product to be deposited over the stencil;
- it transfers it through the apertures 3 in the stencil or the screen 2.

The force of transfer can only be exerted if there is displacement of the wiper. This force is not constant over the whole length of the wiper. It is at its maximum at the end of the wiper and it decreases along the strip. Because of this the result of the transfer is directly linked to the viscosity of the product, wherein it is known that this will change quickly, and to the force of transfer resulting from the sloping of the wiper and from its movement.

At the point of contact between the wiper and the stencil, the wiper fulfils a triple function:

- sealing (with regard to the apertures in the stencil);
- wiping the stencil, which allows removal of the surplus product;
- contact between the stencil 2 and the substrate 1, there being no contact downstream and upstream of the wiper.

The fact that a single tool, the wiper, fulfils all these functions makes independent action with respect to each of these functions impossible within the known technology. Moreover, this known technology has disadvantages. The product to be distributed through the apertures is always downstream of the wiper which establishes a contact on its bearing line upon the stencil. Because of this, as shown in Figure 1, when the filling of the aperture takes place, it is always in a zone where the stencil is not in contact with the substrate. Because of this, as shown in Figure 1, the product can be pushed in between the stencil and the substrate, making on the one hand undesirable lines on the substrate and on the other hand fouling the stencil which must be cleaned frequently.

The disadvantageous non-contact in the actual deposition of the product nevertheless has the advantage of aiding the unmoulding of the deposit, as shown by 3B of the same figure. The ideal is to obtain non-contact equal to zero at the time of deposition and greater than zero following the deposition.

The embodiments of the invention to be described allow the essential functions to be dissociated, that is to say dragging, transfer of the viscous product and wiping of the excess, while providing the original solutions to the other functions: contact and non-contact, sealing, quality of deposits, and to the problems posed by the variations in rheology of the product or by its heterogeneous nature.

The method embodying to the invention for making deposits of a viscous product on a substrate I through the apertures in a stencil 2 or a screen involves containing a quantity of viscous product in a hollow receptacle. Preferably, this hollow receptacle and its members and accessories, which will be described later, is designed as a disposable or recyclable container (for factory filling) delivered directly from the factory with a quantity of viscous product to be deposited. This arrangement allows handling of the bulk viscous product, using a spatula, from the pot in which it is traditionally delivered, to be avoided. As the device is designed to be installed directly onto the screen printing machine for producing electronic cards, it can be removed either when it is empty or after use.

According to the method, in the hollow receptacle a pressure is exerted on the viscous product, which is pushed towards a lower aperture in the receptacle directed towards the stencil. The length of this aperture is preferably adapted to the dimensions of the substrate on which the different deposits are to be made, or of the zone of the substrate on which the deposits are to be made; actually the width of the aperture is adapted to the more or less rapid speed of displacement of the device on the stencil and thus directly in relation to the speed at which the screen printing has to be done.

A high printing speed can be obtained without adding additives to the paste to modify the rheology of the paste.

The lower aperture of the receptacle containing viscous (or pasty) product is delimited by sealing and wiping members. The pressure exerted on the product in the receptacle contributes to exerting a pressure upon said receptacle, by means of the sealing and wiping members, onto the stencil and the substrate, which, as described hereinafter, contributes both to making a zone of contact between the stencil and the substrate, this zone being facing the aperture between the sealing members which delimit this aperture, and to pressurising the sealing members and wiping off the excess product. The contact zone contributes to good transfer of the product through the apertures of the stencil, without smears under the stencil, or excess. This contact zone moves on the stencil at the same time as the device, the non-contact being made upstream following passage of the sealing wiping members.

According to the method to be described, the pressure exerted in the receptacle on the product remains constant as far as the distribution aperture and contact with the stencil. This pressure in the device is exerted by the product upon the sealing wiping members which delimit the delivery aperture and are transversal to the direction of downward delivery of the product, which contributes to increasing the sealing function.

According to the method to be described, the surface on which the pressure is exerted in the container on the product is larger than the distribution aperture delimited by the sealing members and a pressure is exerted by the product upon the stencil at the level of the aperture and a pressure is exerted by the product on the sealing members which are both partially transversal to the section of the container and to the downward direction of displacement of the product.

The uniformity of the amount of pressure exerted in the cavity of the receptacle or container, the internal walls of which are rectilinear and/or parallel, avoids dissociation of the components of the product because of differences in density of said components.

The method embodying the invention furthermore has a phase of homogenisation of the active constituent of the product. This phase is carried out under the influence of the pressure exerted on the product in combination with a homogenising member which will be described hereinafter. Preferably, this homogenisation is obtained by division into parts of identical volume in the zone between the receptacle itself and the distribution aperture delimited by the sealing members. The action of the wipers as the receptacle is displaced also assists this homogenisation as discussed further below.

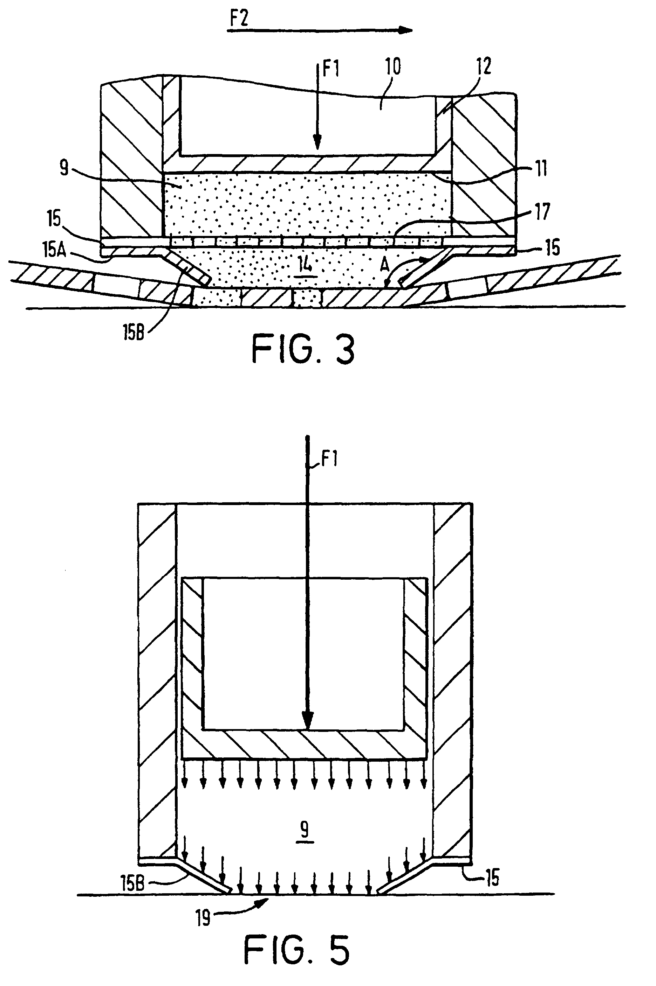

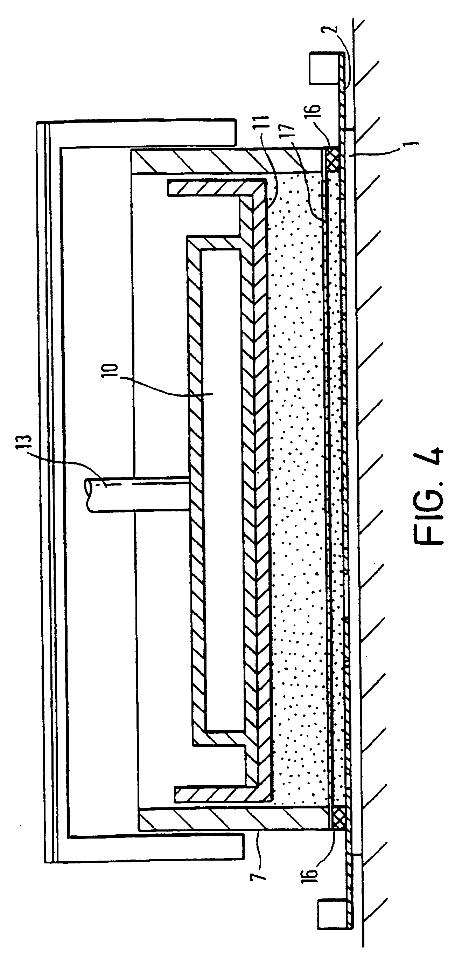

Figure 2 shows a view in transverse section of the device for implementing the method; this view is complemented by Figure 3 which is a view in partial transverse section, and by Figure 4 which is a view in longitudinal section.

Figure 2 shows the substrate 1, resting on a table, the stencil or screen 2 provided with apertures 3 and the distribution device 6 for the product. The distribution device is constituted by a receptacle 7 or container, the internal wall or walls of which is or are rectilinear and parallel. In the internal cavity of the receptacle 7, the walls of which are vertical, a charge of product, for example of soldering paste, labelled 9, is placed, for example in the factory.

A piston 10 is movably mounted in the internal cavity of the receptacle. The piston has a head 11 (Figure 3), the surface of which is planar. It is provided with vertical walls 12 behind its planar head, which slide on the vertical wall or walls of the receptacle and contribute to the guiding of the piston. A vertical pressure is exerted on a rod 13 of the piston (Figure 2) according to the arrow F1 of Figure 3. This vertical pressure is delivered to the rod 13 of the piston by a pressure source and a member of the screen printing machine capable of transmitting this pressure. This pressure is exerted in a uniform manner upon the product 9, the hollow receptacle containing the product and the piston having the same section from top to bottom.

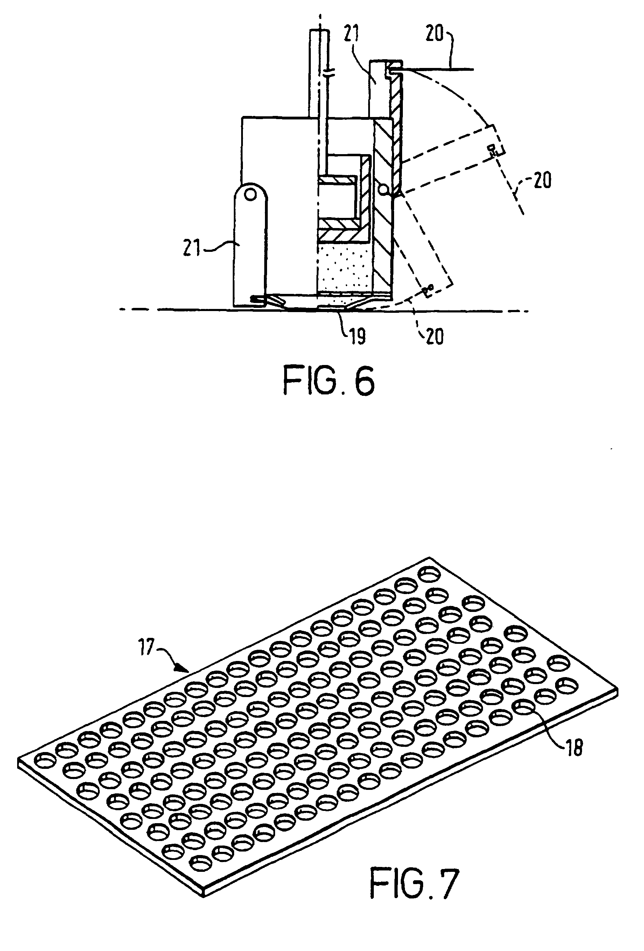

The receptacle is open towards the bottom by means of a distribution aperture 14, delimited by sealing members 15 and 16 and an aperture 19. At the base of the receptacle there is arranged a transversal member 17 for homogenisation by division of the pasty and viscous product having a heterogeneous composition. This member is constituted by a perforated grille or by a perforated wall, the perforations of which are, as shown in Figure 7, all of the same size and made according to a constant spacing and pitch. Preferably, the perforations 18 of the grille are circular. The grille fulfils both a function of holding the product in the cavity of the receptacle and of transmitting the pushing of the piston to the device which is pushed onto the stencil.

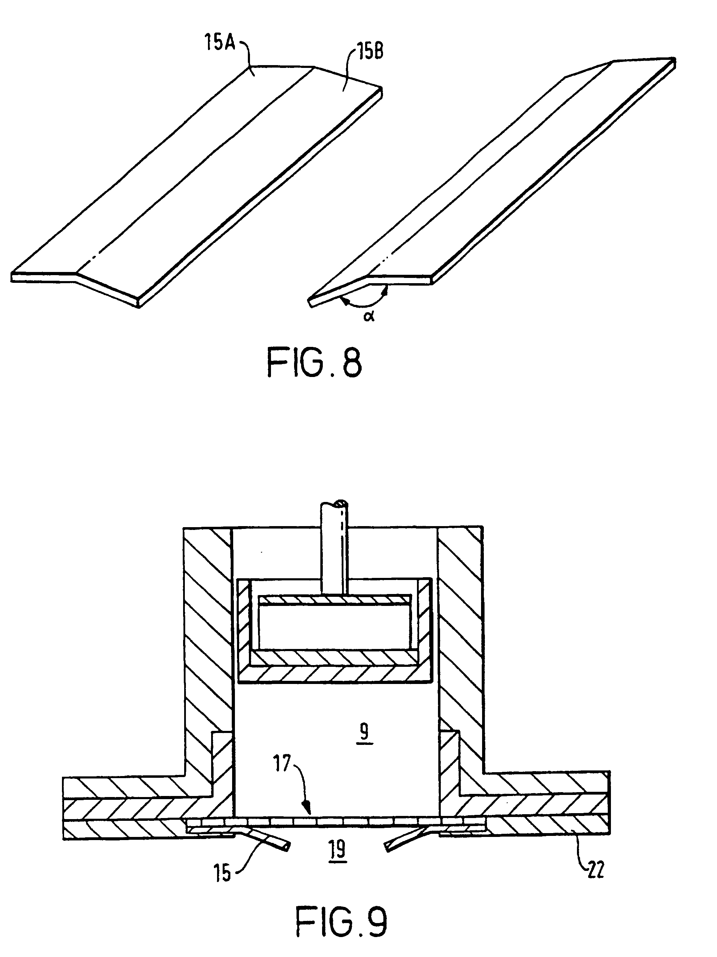

Below the grille there are arranged the sealing members which delimit the aperture 19 (Figure 3) for delivering the product. The aperture 19 is of smaller dimensions than the receptacle as shown in Figure 3. The sealing members 15 are shown in Figures 2 and 3 with the device embodying to the invention, and by themselves in Figure 8. The sealing members 16 are shown in Figure 4, which is a view in longitudinal axial section of the device.

The members 15 are wipers fixed by a part 15A to the wall of the receptacle, and a part 15B of which is transversal to the lower section of the receptacle and to the direction of descent of the product under the pressure of the piston. The wipers are mounted opposite one another, their inclined parts 15B being facing and in opposite directions. The inclination of their part 15B is greater than vertical, and can be between 120° and 180° with respect to the horizontal in the zone of distribution of the product onto the stencil following the angle (Figure 3). In the case in which the wiper is inclined at 180°, its extremity can be bevelled or inclined. The angle formed by the wiper and the substrate or the stencil outside the zone where the product is delivered at the level of the aperture 19 is of a value which is complementary to those previously set out.

The wipers 15 can be of any suitable material, metal or synthetic materials; they must be of a hard, flexible material which is deformable without exceeding the elastic limit. Advantageously, wipers such as described are arranged on the long longitudinal sides of the device and approach the stencil and the substrate transversally. Each wiper 15 has the function of lifting, by detachment, the excess product remaining on the stencil. This functioning is more efficient than the wiping according to Figure 1 in which the product is pushed by the wiper.

The transverse sides or short sides of the device, which has the shape of a rectangular parallelepiped, can either be provided with wipers providing sealing as described previously, or be provided with sealing members 16 such as are shown in Figure 4 and which can be constituted either by a profiled section in a flexible material, or by an elastically deformable profiled section which can, for example, be constituted by a profiled section which is hollow or made from closed cell foam. The essential function of the members 16 is that of lateral sealing intended to avoid overflow of the product by creep, as shown in Figures 2 - 5.

Advantageously it can be envisaged that the device is provided with only one wiper such as 15 in a flexible material, and that the other edges of the aperture are provided with sealing members such as 16. In this case, the device could only function in one direction.

The pressure (according to the arrow F1 or to the rod 13) exerts a pressure on the pasty and/or viscous product constituting the soldering paste. Together with this pressure, a displacement movement according to the arrow F2 or in the opposite direction is provided to the device to allow it to cover the surface of the stencil and of the substrate. The vertical pressure of the piston in the receptacle pushes the pasty product both through the lower aperture 19 towards the stencil and the substrate, through the grille 17 (not shown in Figure 5) and on the sealing members 15, which contributes to keeping them pressurised and to wiping off the excess product by simultaneous displacement with the device.

The inclination of the wipers as defined hereinabove, and which is slight with respect to the stencil, contributes to detaching and lifting the excess product which remains in the zone delimited by the grille 17 and the lips of the wipers. As the wipers 15 are arranged in opposite directions, the function of wiping is done whatever the direction of displacement of the device.

The grille 17 functions as a homogenising element for the paste or soldering paste by division thereof, in that it leaves the grille in separate strings or small rods, the section of which corresponds to that of each of the perforations in the grille, said strings or rods reagglomerating by rubbing on the stencil or the screen. The open surface of the grille can be 20% to 90% of the total surface of the grille.

The lower distribution aperture 19 can be of dimensions adapted according to the speed of application desired and/or the viscosity of the product to be deposited. The invention is applicable to the application of very high viscosity products as well as to very low viscosity products. This adaptation of the aperture 19 can relate essentially to its width, that is to say the distance between the lips 15B of the wipers 15 which, for this purpose, can be interchangeable, for example if the container device and its internal receptacle has a constant given section. It is also possible to envisage that the section (the width of the receptacle and of the piston) is different and more or less large, with an aperture 19 between the more or less large lips 15B, where the different devices are adapted to a certain rheology. The length of the device, as set out above, is such that the length of the aperture 19 covers the whole of the width of the substrate and/or of the stencil or of the zone on which the deposits are to be made.

When the deposit is made by displacement of the device together with the pressure exerted on the piston, the contact surface of the product, determined by the dimensions of the aperture 19, being large, it is inconceivable to lift the receptacle distributer device off the stencil.

According to an embodiment of the invention this removal is done by detachment of the mass of product obtained by interposing a wall between the wipers and the product on the one hand, and the stencil on the other hand. Advantageously, as shown in Figure 6, the receptacle is provided with at least one wall 20. This wall 20 is carried by any suitable member which allows it to be positioned outside the field of the aperture 19, or below it. Preferably, this wall 20 is a flexible, rigid or semirigid wall acting as a blade. In the embodiment shown in Figure 6, the wall 20 is carried by an articulated and moveable flap 21 in order to occupy the positions such as shown in broken lines. Preferably, the flap is articulated on the external face of the receptacle, and it is placed in the upper position during the phase of displacement of the device. Preferably, the device comprises two walls 20 and two flaps 21 articulated on each of its external front and rear faces.

The grille can be removable and/or interchangeable according, for example, to the proportion of open surface which it is to be given.

Figure 9 shows a view in transversal section of an embodiment of the device in which the grille 17 and the lip or lips 15 are carried by a device 22 which can be fixed, such that it can be dismantled, below the receptacle and allows the mounting and dismantling of the grille and or the wiper or wipers and the changing of one or the other of the grille and wiper assembly.

The distribution receptacle device 6 embodying to the invention is designed to function in a sealed manner by contact with the stencil and the substrate. This sealing allows products which are sensitive to humidity such as, for example, silicons, to be delivered.

The aperture 19 can be covered over by a cover (not shown) prior to use of the device, which can be glued below the grille and which can be peeled or torn off.

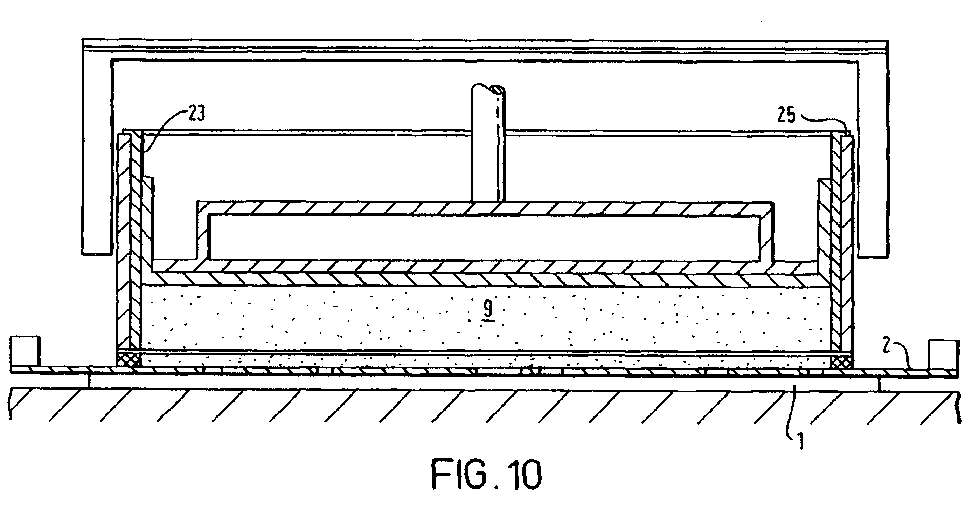

Figure 10 shows a view in longitudinal section of an embodiment of the device for deposition of pasty or viscous product with an intermediate product receptacle.

The product 9 is contained in an intermediate receptacle 23 closed at the top with a sliding cover 24, which is introduced into the cavity of the receptacle and the piston 10 pushes the product in this intermediate receptacle by bearing on the sliding cover. The intermediate receptacle is a charge filled at the factory directly by the product manufacturer.

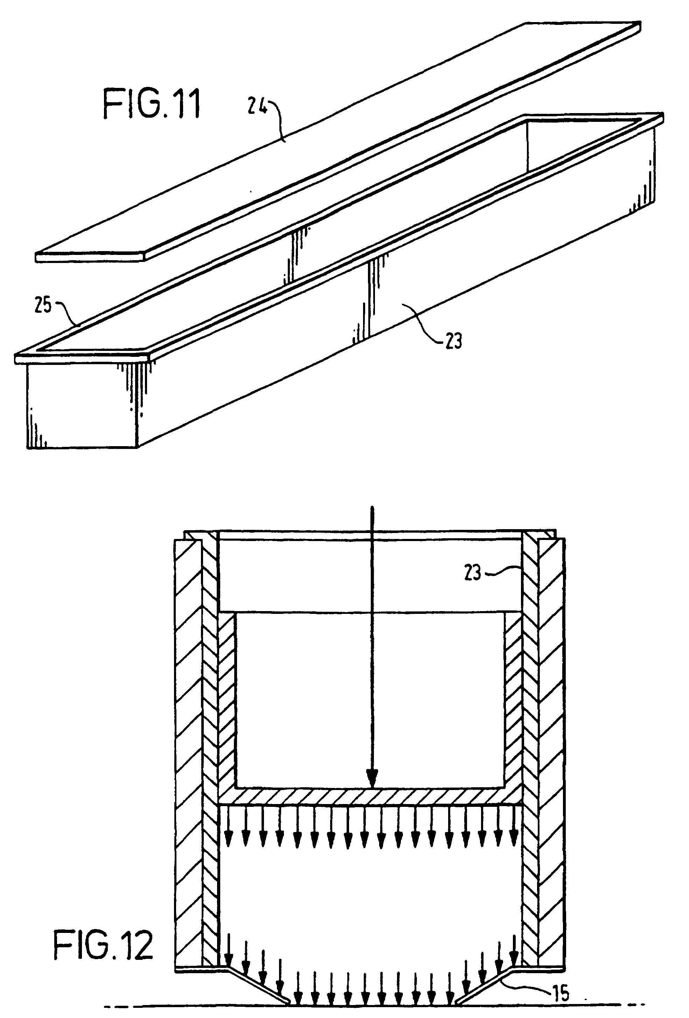

The intermediate receptacle shown in Figure 11 has a shape corresponding to that of the internal cavity of the receptacle of the device. These walls are vertical with an aperture at the top and at the bottom. These apertures can be covered in the factory after filling by any known means and uncovered at the time of installation.

Advantageously, the intermediate receptacle is provided with means for locking it in the housing of the device which is preferably a shoulder 25 totally or partially peripheral on its top edge. This intermediate receptacle has smooth and rectilinear internal walls. It is designed as a disposable or recyclable cartridge. The cover 24 rests on the pasty product. The cover 24 shown in Figure 11 is a planar plate with dimensions slightly smaller than the top aperture of the receptacle so that it can slide in the receptacle under the pressure of the piston which pushes the pasty product.

The significance of this improvement is that it simplifies the manufacture of the device, the cost of which can be less high, and that it facilitates the handling of the pasty or viscous product and/or its mixing or heating prior to use; it also facilitates loading.

According to another embodiment of the invention, the intermediate receptacle 23 can integrate functions of the device which receives it; in particular it can be provided at the level of the lower aperture with an openwork grille 17 and its aperture can be delimited by sealing members 15, the lips of which are in opposite directions. The construction facilitates production; the grille and the lips can be moulded with the intermediate receptacle.

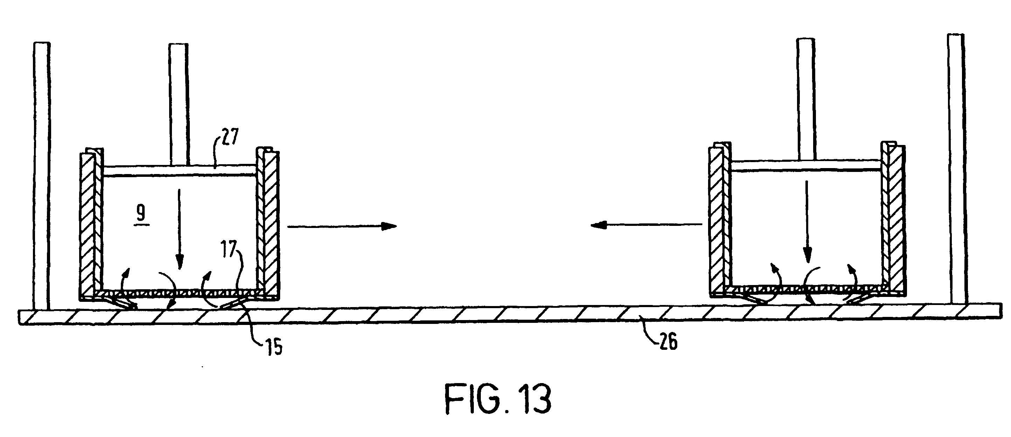

Figure 13 shows a product mixing device fitted to the receptacle embodying the invention used before installation on the machine. It comprises a planar plate 26, preferably rigid, under the aperture, which is substituted for the stencil. The device is guided, for example by means of a rail which is not shown, or any other mechanical means, parallel to the plate. A pressure is exerted by a piston 27 which can be of the same type as the piston 10 and which bears upon the product 9 which passes through the grill 17.

The forward movement, that is to say from left to right, causes the setting in motion and the rotation of the paste and its agitation and its homogenisation at the time of passage through the apertures of the grille in the clockwise direction. The backward movement, that is to say from right to left, causes the setting in motion, the rotation and the homogenisation of the paste in the opposite direction. Several forward-backward movements provide mixing of the soldering paste, the wipers lifting the paste as shown by the arrows in the figure, so that the paste passes upwards through the grille and is pushed back downward through the grille by the piston. This gives the paste the rheological qualities suitable for its application from the start of its use, whether for new cartridges or for cartridges which still contain some product and which have to be re-used after a downtime. It will of course be appreciated that this rotation and homogenisation of the paste also occurs during displacement of the device 6 in a printing operation.

The device embodying the invention does not require high working pressures.

As it is designed as a sealed container, the device embodying the invention eliminates the operations of cleaning the devices according to the prior art and fulfils the health and safety criteria for the users, who do not have to come into direct contact with product.

According to the criteria of application and/or the nature of the products to be deposited, a distribution device embodying the invention can be insulated and/or provided with a thermostat, heated or cooled, without it being necessary to provide this insulation or conditioning for the whole machine, as was the case with the prior art.

**Claims**

1. A device for depositing viscous product (9) onto a substrate (1) through apertures (3) of a stencil (2) disposed over the substrate (1), comprising:

    a receptacle (7) including a cavity for containing viscous product (9) to be deposited onto the substrate (1), the receptacle (7) having first and second opposed longitudinal sides and a lower surface including an aperture through which product (9) is in use pushed under pressure towards the stencil (2);

a piston (10) movable in the cavity of the receptacle (7) to apply a uniform pressure to the product (9) therein in pushing the same therefrom;

a flexible wiper (15) attached to the lower surface of the receptacle (7) along one of the longitudinal sides thereof, wherein the wiper (15) is inclined at an angle of between 120 and 180° with respect to a plane substantially parallel to the lower surface of the receptacle (7) and arranged such that, when product (9) is pushed through the aperture in the receptacle (7), product (9) is pushed against the wiper (15), causing the wiper (15) to be pushed against the stencil (2), and such that, when the device is displaced over the stencil (2) in a direction substantially perpendicular to the longitudinal sides of the receptacle (7), an excess amount of the product (9) remaining on the stencil (2) is detached and lifted by the action of the wiper (15) such as to pass up into the receptacle (7) through the aperture therein and pushed back downwards by the action of the piston (10), whereby the excess amount of the product (9) is rotated in an area above and below the aperture in the receptacle (7).

2. The device of claim 1, comprising first and second flexible wipers (15) attached to the lower surface of the receptacle (7) along respective ones of the longitudinal sides thereof, wherein the wipers (15) are each inclined at an angle with respect to the plane substantially parallel to the lower surface of the receptacle (7) and arranged such that, when product (9) is pushed through the aperture in the receptacle (7), product (9) is pushed against the wipers (15), causing the wipers (15) to be pushed against the stencil (2), and such that, when the device is displaced over the stencil (2) in either of the directions substantially perpendicular to the longitudinal sides of the receptacle (7), an excess amount of the product (9) remaining on the stencil (2) is detached and lifted by one of the first and second wipers (15) and pushed up into the receptacle (7) through the aperture therein such that the excess amount of the product (9) is rolled in an area above and below the aperture in the receptacle (7).

3. The device of claim 1 or 2, wherein the piston (10) includes a planar head.

4. The device of any of claims 1 to 3, further comprising first and second sealing members (16) disposed at the ends of the or each wiper (15) to provide lateral sealing.

5. The device of any of claims 1 to 4, further comprising a perforated grille (17) disposed at the aperture of the receptacle (7), through which the excess amount of the product (9) is in use pushed.

6. The device of claim 5, wherein the aperture coefficient of the grille (17) is between 20 and 90 %.

7. The device of claim 5 or 6, wherein the grille (17) is removable.

8. The device of claim 7, wherein the grille (17) and the or each wiper (15) form an assembly removable from the receptacle (7).

9. The device of any of claims 1 to 8, wherein the internal walls (8) of the cavity of the receptacle (7) are orthogonal to the plane substantially parallel to the lower surface of the receptacle (7).

10. The device of claim 9 when appendant upon any of claims 5 to 8, wherein the grille (17) and the internal walls (8) of the cavity of the receptacle (7) are orthogonal.

11. The device of any of claims 1 to 10, further comprising a removable intermediate receptacle (23) which is insertable in the receptacle (7).

12. The device of claim 11, wherein the cavity is defined by the intermediate receptacle (23), in which the piston (10) is movable.

13. The device of claim 11 or 12, when appendant upon claim 6, wherein the intermediate receptacle (23) includes the grille (17).

14. The device of any of claims 1 to 13, wherein the product (9) is solder paste and the substrate (1) is a printed circuit board.

15. The device of any of claims 1 to 14, in combination with a stencil (2) for location over the substrate (1).

16. A method of depositing viscous product (9) onto a substrate (1) through apertures (3) of a stencil (2) disposed over the substrate (1), comprising the steps of:

providing a substrate (1);
providing a stencil (2) including apertures (3) over the substrate (1);
providing a device, comprising a receptacle (7) including a cavity containing viscous product (9) to be deposited onto the substrate (1), the receptacle (7) having first and second opposed longitudinal sides and a lower surface including an aperture through which product (9) is in use pushed under pressure towards the stencil (2), and a flexible wiper (15) attached to the lower surface of the receptacle (7) along one of the longitudinal sides thereof, the wiper (15) being inclined at an angle of between 120 and 180° with respect to a plane substantially parallel to the lower surface of the receptacle (7);

applying a uniform pressure to the product (9) in the cavity of the receptacle (7) to push the same therefrom, which product (9) is pushed against the wiper (15) and causes the wiper (15) to be pushed against the stencil (2); and displacing the device over the stencil (2) in a direction substantially perpendicular to the longitudinal sides of the receptacle (7) such as to cause an excess amount of the product (9) remaining on the stencil (2) to be detached and lifted by the action of the wiper (15) such as to pass up into the receptacle (7) through the aperture therein and pushed back downwards by the action of a piston (10), whereby the excess amount of the product (9) is rotated in an area above and below the aperture in the receptacle (7).

17. The method of claim 16, wherein the device comprises first and second flexible wipers (15) attached to the lower surface of the receptacle (7) along respective ones of the longitudinal sides thereof, the wipers (15) each being inclined at an angle with respect to the plane substantially parallel to the lower surface of the receptacle (7).

18. The method of claim 17, wherein the device is reciprocatingly displaced over the stencil (2).

19. The method of any of claims 16 to 18, further comprising the step of displacing the device over a non-perforated plate (26), while applying a uniform pressure to the product (9) in the cavity of the receptacle (7) and prior to displacement over the stencil (2), so as to effect mixing of the product (9).

20. The method of any of claims 16 to 19, wherein the device further comprises first and second sealing members (16) disposed at the ends of the or each wiper (15) to provide lateral sealing.

21. The method of any of claims 16 to 20, wherein the device further comprises a perforated grille (17) disposed at the aperture of the receptacle (7), through which the excess amount of the product (9) is pushed.

22. The method of claim 21, wherein the aperture coefficient of the grille (17) is between 20 and 90 %.

23. The method of claim 21 or 22, wherein the grille (17) is removable.

24. The method of claim 23, wherein the grille (17) and the or each wiper (15) form an assembly removable from the receptacle (7).

25. The method of any of claims 16 to 24, wherein the internal walls (8) of the cavity of the receptacle (7) are orthogonal to the plane substantially parallel to the lower surface of the receptacle (7).

26. The method of claim 25 when appendant upon any of claims 21 to 24, wherein the grille (17) and the internal walls (8) of the cavity of the receptacle (7) are orthogonal.

27. The method of any of claims 16 to 26, wherein the device further comprises a removable intermediate receptacle (23) which is insertable in the receptacle (7).

28. The method of claim 27, wherein the cavity is defmed by the intermediate receptacle (23).

29. The method of claim 27 or 28 when appendant upon claim 21, wherein the intermediate receptacle (23) includes the grille (17).

30. The method of any of claims 16 to 29, wherein the product (9) is solder paste and the substrate (1) is a printed circuit board.

**Patentansprüche**

1. Vorrichtung zur Aufbringung eines viskosen Produkts (9) auf ein Substrat (1) durch Öffnungen (3) einer über dem Substrat (1) angeordneten Schablone (2) hindurch, folgendes umfassend:

    einen Behälter (7) mit einem Hohlraum zur Aufnahme des auf das Substrat (1) aufzubringenden viskosen Produkts (9), wobei der Behälter (7) einander gegenüberliegend eine erste und eine zweite Längsseite sowie eine untere Fläche mit einer Öffnung hat, durch die hindurch das Produkt (9) im Gebrauch unter Druck zur Schablone (2) hin gedrückt wird; einen Kolben (10), der im Hohlraum des Behälters (7) bewegt werden kann, um beim Herausdrücken des darin enthaltenen Produkts (9) aus dem Behälter (7) einen gleichmäßigen Druck auf dieses auszuüben; einen flexiblen Abstreifer (15), der an der unteren Fläche des Behälters (7) an einer dessen Längsseiten entlang angebracht ist, wobei der Abstreifer (15) unter einem Winkel von zwischen 120° und 180° bezüglich einer im wesentlichen parallel zur unteren Fläche des Behälters (7) verlaufenden Ebene geneigt sowie derart angeordnet ist, dass beim Herausdrükken des Produkts (9) durch die Öffnung im Behälter (7) hindurch dieses Produkt (9) gegen den Abstreifer (15) gedrückt wird, wodurch der Abstreifer (15) wiederum gegen die Schablone (2) gedrückt wird, und derart, dass bei Verschieben der Vorrichtung über der Schablone (2) in eine Richtung im wesentlichen senkrecht zu den Längsseiten des Behälters (7) eine auf der Schablone (2) verbliebene überschüssige Menge des Produkts (9) unter Wirkung des Abstreifers (15) abgelöst und hochgeführt wird, so dass sie über die Behälteröffnung hoch und in den Behälter (7) hinein verläuft, und unter Wirkung des Kolbens (10) wieder zurück nach unten gedrückt wird, wodurch die überschüssige Menge des Produkts (9) in einem Bereich über und unter der Öffnung im Behälter (7) gedreht wird.

2. Vorrichtung nach Anspruch 1, umfassend einen ersten und einen zweiten flexiblen Abstreifer (15), die an der unteren Fläche des Behälters (7) entlang jeweiliger Längsseiten dessen befestigt sind, worin die Abstreifer (15) jeweils in einem Winkel bezüglich der im wesentlichen parallel zur unteren Fläche des Behälters (7) verlaufenden Ebene geneigt sowie derart angeordnet sind, dass beim Herausdrükken des Produkts (9) aus der Öffnung im Behälter (7) das Produkt (9) gegen die Abstreifer (15) gedrückt wird, wodurch die Abstreifer (15) wiederum gegen die Schablone (2) gedrückt werden, und derart, dass beim Verschieben der Vorrichtung über der Schablone (2) in einer der beiden Richtungen im wesentlichen senkrecht zu den Längsseiten des Behälters (7) eine auf der Schablone (2) verbliebene überschüssige Menge des Produkts (9) von einem der ersten und zweiten Abstreifer (15) abgelöst und hochgeführt wird und durch die im Behälter (7) vorgesehene Öffnung in diesen hinein hochgedrückt wird, so dass die überschüssige Menge des Produkts (9) in einem Bereich über und unter der Öffnung im Behälter (7) gerollt wird.

3. Vorrichtung nach Anspruch 1 oder 2, worin der Kolben (10) einen ebenen Kopf umfasst.

4. Vorrichtung nach jedem der Ansprüche 1 bis 3, des weiteren umfassend ein erstes und ein zweites Dichtungselement (16), die zur Bewirkung einer seitlichen Abdichtung jeweils an den Enden des bzw. jedes Abstreifers (15) angeordnet sind.

5. Vorrichtung nach jedem der Ansprüche 1 bis 4, des weiteren umfassend ein an der Öffnung des Behälters (7) angeordnetes Lochgitter (17), durch das die überschüssige Menge des Produkts (9) im Gebrauch hindurch gedrückt wird.

6. Vorrichtung nach Anspruch 5, worin der Öffnungskoeffizient des Gitters (17) zwischen 20 % und 90 % beträgt.

7. Vorrichtung nach Anspruch 5 oder 6, worin das Gitter (17) abnehmbar ist.

8. Vorrichtung nach Anspruch 7, worin das Gitter (17) und der bzw. jeder Abstreifer (15) einen vom Behälter (7) abnehmbaren Aufbau bilden.

9. Vorrichtung nach jedem der Ansprüche 1 bis 8, worin die Innenwände (8) des Hohlraums des Behälters (7) orthogonal zu der im wesentlichen parallel zur unteren Fläche des Behälters (7) verlaufenden Ebene sind.

10. Vorrichtung nach Anspruch 9 bei Abhängigkeit von jedem der Ansprüche 5 bis 8, worin das Gitter (17) und die Innenwände (8) des Hohlraums des Behälters (7) orthogonal sind.

11. Vorrichtung nach jedem der Ansprüche 1 bis 10, des weiteren umfassend einen abnehmbaren Zwischenbehälter (23), der in den Behälter (7) einsetzbar ist.

12. Vorrichtung nach Anspruch 11, worin der Hohlraum von dem Zwischenbehälter (23) definiert wird, in dem der Kolben (10) bewegt werden kann.

13. Vorrichtung nach Anspruch 11 oder 12 bei Abhängigkeit von Anspruch 6, worin der Zwischenbehälter (23) das Gitter (17) enthält.

14. Vorrichtung nach jedem der Ansprüche 1 bis 13, worin das Produkt (9) Lötpaste und das Substrat (1) eine Leiterplatte ist.

15. Vorrichtung nach jedem der Ansprüche 1 bis 14 in Kombination mit einer Schablone (2) zur Anordnung über dem Substrat (1).

16. Verfahren zur Aufbringung eines viskosen Produkts (9) auf ein Substrat (1) durch Öffnungen (3) einer über dem Substrat (1) angeordneten Schablone (2) hindurch, folgende Schritte umfassend:

Bereitstellung eines Substrats (1);
Bereitstellung einer Schablone (2) mit Öffnungen (3) über dem Substrat (1);
Bereitstellung einer Vorrichtung, umfassend einen Behälter (7) mit einem Hohlraum, der ein viskoses Produkt (9) zur Aufbringung auf das Substrat (1) enthält, wobei der Behälter (7) einander gegenüberliegende eine erste und eine zweite Längsseite sowie eine untere Fläche mit einer Öffnung hat, durch die das Produkt (9) bei Gebrauch unter Druck zur Schablone (2) hin gedrückt wird, und einen flexiblen Abstreifer (15), der an der unteren Fläche des Behälters (7) entlang einer dessen Längsseiten angebracht ist, wobei der Abstreifer (15) in einem Winkel zwischen 120° und 180° bezüglich einer im wesentlichen parallel zur unteren Fläche des Behälters (7) verlaufenden Ebene geneigt ist;

Anlegen eines gleichmäßigen Druckes an das Produkt (9) im Hohlraum des Behälters (7), um es aus diesem herauszudrücken, wobei das Produkt (9) gegen den Abstreifer (15) gedrückt wird und diesen dabei gegen die Schablone (2) drückt; und

Verschieben der Vorrichtung über der Schablone (2) in eine Richtung im wesentlichen senkrecht zu den Längsseiten des Behälters (7), um eine auf der Schablone (2) verbliebene überschüssige Menge des Produkts (9) unter Wirkung des Abstreifers (15) abzulösen und hoch zu führen, um dieses durch die Behälteröffnung in den Behälter (7) hoch und in diesen hinein zu leiten, und unter Wirkung eines Kolbens (10) wieder nach unten zu drükken, wodurch die überschüssige Menge des Produkts (9) in einem Bereich über und unter der Öffnung im Behälter (7) gedreht wird.

17. Verfahren nach Anspruch 16, worin die Vorrichtung einen ersten und einen zweiten flexiblen Abstreifer (15) umfasst, die an der unteren Fläche des Behälters (7) entlang jeweiliger dessen Längsseiten befestigt sind, wobei die Abstreifer (15) jeweils in einem Winkel bezüglich der im wesentlichen parallel zur unteren Fläche des Behälters (7) verlaufenden Ebene geneigt sind.

18. Verfahren nach Anspruch 17, worin die Vorrichtung über der Schablone (2) hin- und her verschoben wird.

19. Verfahren nach jedem der Ansprüche 16 bis 18, des weiteren umfassend den Schritt des Verschiebens der Vorrichtung über einer ungelochten Platte (26) unter gleichzeitigem Anlegen eines gleichmäßigen Drucks an das Produkt (9) im Hohlraum des Behälters (7) und vor dem Verschieben über der Schablone (2), um ein Mischen des Produkts (9) zu bewirken.

20. Verfahren nach jedem der Ansprüche 16 bis 19, worin die Vorrichtung des weiteren ein erstes und ein zweites Dichtungselement (16) umfasst, die zur Bewirkung einer seitlichen Abdichtung an den Enden des bzw. jedes Abstreifers (15) angeordnet sind.

21. Verfahren nach jedem der Ansprüche 16 bis 20, worin die Vorrichtung des weiteren ein an der Öffnung des Behälters (7) angeordnetes Lochgitter (17) umfasst, durch das die überschüssige Menge des Produkts (9) hindurch gedrückt wird.

22. Verfahren nach Anspruch 21, worin der Öffnungskoeffizient des Gitters (17) zwischen 20 % und 90 % beträgt.

23. Verfahren nach Anspruch 21 oder 22, worin das Gitter (17) abnehmbar ist.

24. Verfahren nach Anspruch 23, worin das Gitter (17) und der oder jeder Abstreifer (15) einen vom Behälter (7) abnehmbaren Aufbau bilden. ,

25. Verfahren nach jedem der Ansprüche 16 bis 24, worin die Innenwände (8) des Hohlraums des Behälters (7) orthogonal zu der im wesentlichen parallel zur unteren Fläche des Behälters (7) verlaufenden Ebene sind.

26. Verfahren nach Anspruch 25 bei Abhängigkeit von jedem der Ansprüche 21 bis 24, worin das Gitter (17) und die Innenwände (8) des Hohlraums des Behälters (7) orthogonal sind.

27. Verfahren nach jedem der Ansprüche 16 bis 26, worin die Vorrichtung des weiteren einen abnehmbaren Zwischenbehälter (23) umfasst, der in den Behälter (7) einsetzbar ist.

28. Verfahren nach Anspruch 27, worin der Hohlraum durch den Zwischenbehälter (23) definiert ist.

29. Verfahren nach Anspruch 27 oder 28 bei Abhängigkeit von Anspruch 21, worin der Zwischenbehälter (23) das Gitter (17) enthält.

30. Verfahren nach jedem der Ansprüche 16 bis 29, worin das Produkt (9) Lötpaste und das Substrat (1) eine Leiterplatte ist.

**Revendications**

1. Dispositif pour déposer un produit visqueux (9) sur un substrat (1) à travers des orifices (3) d'un pochoir (2) disposé par-dessus le substrat (1), comprenant :

    un réservoir (7) englobant une cavité destinée à contenir un produit visqueux (9) qui doit être déposé sur le substrat (1), le réservoir (7) possédant des premier et deuxième côtés longitudinaux opposés et une surface inférieure englobant un orifice à travers lequel le produit (9) est, en état de marche, poussé sous pression en direction du pochoir (2) ;

un piston (10) mobile dans la cavité du réservoir (7) pour exercer une pression uniforme sur le produit (9) qui s'y trouve en le poussant vers l'extérieur ;

une racle d'essuyage flexible (15) fixée à la surface inférieure du réservoir (7) le long d'un de ses côtés longitudinaux, la racle d'essuyage (15) étant inclinée en formant un angle entre 120 et 180° par rapport à un plan essentiellement parallèle à la surface inférieure du réservoir (7) et arrangée de telle sorte que, lorsque le produit (9) est poussé à travers l'orifice pratiqué dans le réservoir (7), le produit (9) est poussé contre la racle d'essuyage (15), si bien que la racle d'essuyage (15) est poussée contre le pochoir (2), et de telle sorte que, lorsque le dispositif est soumis à un déplacement par-dessus le pochoir (2) dans une direction essentiellement perpendiculaire aux côtés longitudinaux du réservoir (7), une quantité en excès du produit (9) qui subsiste sur le pochoir (2) s'en détache et est soulevée par l'action de la racle d'essuyage (15) de façon à passer dans le réservoir (7) à travers l'orifice qui y est pratiqué, avant d'être poussée en retour vers le bas par l'action du piston (10), la quantité en excès du produit (9) étant soumise à une rotation dans une zone située au-dessus et en dessous de l'orifice pratiqué dans le réservoir (7).

2. Dispositif selon la revendication 1, comprenant des première et deuxième racles d'essuyage flexibles (15) fixées à la surface inférieure du réservoir (7) le long de ses côtés longitudinaux respectifs, les racles d'essuyage (15) étant respectivement inclinées en formant un angle par rapport au plan essentiellement parallèle à la surface inférieure du réservoir (7) et arrangées de telle sorte que, lorsque le produit (9) est poussé à travers l'orifice pratiqué dans le réservoir (7), le produit (9) est poussé contre les racles d'essuyage (15), si bien que les racles d'essuyage (15) sont poussées contre le pochoir (2), et de telle sorte que, lorsque le dispositif est soumis à un déplacement par-dessus le pochoir (2) dans l'une ou l'autre direction essentiellement perpendiculaire aux côtés longitudinaux du réservoir (7), une quantité en excès du produit (9) qui subsiste sur le pochoir (2) s'en détache et est soulevée par une des première et deuxièmes racles d'essuyage (15) et passe dans le réservoir (7) à travers l'orifice qui y est pratiqué de telle sorte que la quantité en excès du produit (9) est soumise à un roulement dans une zone située au-dessus et en dessous de l'orifice pratiqué dans le réservoir (7).

3. Dispositif selon la revendication 1 ou 2, dans lequel le piston (10) englobe une tête plane.

4. Dispositif selon l'une quelconque des revendications 1 à 3, comprenant en outre des premier et deuxième éléments d'étanchéisation (16) disposés aux extrémités de la racle ou de chaque racle d'essuyage (15) pour obtenir une étanchéisation latérale.

5. Dispositif selon l'une quelconque des revendications 1 à 4, comprenant en outre une grille perforée (17) disposée à l'orifice du réservoir (7), à travers laquelle la quantité en excès du produit (9) est poussée en état de marche.

6. Dispositif selon la revendication 5, dans lequel le coefficient d'ouverture de la grille (17) représente entre 20 et 90 %.

7. Dispositif selon la revendication 5 ou 6, dans lequel la grille (17) est amovible.

8. Dispositif selon la revendication 7, dans lequel la grille (17) et la racle ou chaque racle d'essuyage (15) forment un assemblage amovible par rapport au réservoir (7).

9. Dispositif selon l'une quelconque des revendications 1 à 8, dans lequel les parois internes (8) de la cavité du réservoir (7) sont orthogonales par rapport au plan essentiellement parallèle à la surface inférieure du réservoir (7).

10. Dispositif selon la revendication 9, lorsqu'elle dépend de l'une quelconque des revendications 5 à 8, dans lequel la grille (17) et les parois internes (8) de la cavité du réservoir (7) sont orthogonales.

11. Dispositif selon l'une quelconque des revendications 1 à 10, comprenant en outre un réservoir intermédiaire amovible (23) qui peut venir s'insérer dans le réservoir (7).

12. Dispositif selon la revendication 11, dans lequel la cavité est définie par le réservoir intermédiaire (23) dans lequel le piston (10) est mobile.

13. Dispositif selon la revendication 11 ou 12, lorsqu'elle dépend de la revendication 6, dans lequel le réservoir intermédiaire (23) englobe la grille (17).

14. Dispositif selon l'une quelconque des revendications 1 à 13, dans lequel le produit (9) est de la pâte à braser et le substrat (1) est une plaquette de circuits imprimés.

**15.** Dispositif selon l'une quelconque des revendications 1 à 14, en combinaison avec un pochoir (2), destiné à venir se positionner par-dessus le substrat (1).

**16.** Procédé de déposition d'un produit visqueux (9) sur un substrat (1) à travers des orifices (3) pratiqués dans un pochoir (2) disposé par-dessus le substrat (1), comprenant les étapes consistant à :

procurer un substrat (1) ;
procurer un pochoir (2) englobant des orifices (3) par-dessus le substrat (1) ;
procurer un dispositif, comprenant un réservoir (7) englobant une cavité contenant un produit visqueux (9) qui doit être déposé sur le substrat (1), le réservoir (7) possédant des premier et deuxième côtés longitudinaux opposés et une surface inférieure englobant un orifice à travers lequel le produit (9) est, en état de marche, poussé sous pression en direction du pochoir (2) ; et une racle d'essuyage flexible (15) fixée à la surface inférieure du réservoir (7) le long d'un de ses côtés longitudinaux, la racle d'essuyage (15) étant inclinée en formant un angle entre 120 et 180° par rapport à un plan essentiellement parallèle à la surface inférieure du réservoir (7) ;
exercer une pression uniforme sur le produit (9) dans la cavité du réservoir (7) pour le pousser vers l'extérieur, ledit produit (9) étant poussé contre la racle d'essuyage (15), si bien que la racle d'essuyage (15) est poussée contre le pochoir (2) ; et
déplacer le dispositif par-dessus le pochoir (2) dans une direction essentiellement perpendiculaire aux côtés longitudinaux du réservoir (7), si bien qu'une quantité en excès du produit (9) qui subsiste sur le pochoir (2) s'en détache et est soulevée par l'action de la racle d'essuyage (15) de façon à passer dans le réservoir (7) à travers l'orifice qui y est pratiqué, avant d'être poussée en retour vers le bas par l'action d'un piston (10), la quantité en excès du produit (9) étant soumise à une rotation dans une zone située au-dessus et en dessous de l'orifice pratiqué dans le réservoir (7).

**17.** Procédé selon la revendication 16, dans lequel le dispositif comprend des première et deuxième racles d'essuyage flexibles (15) fixées à la surface inférieure du réservoir (7) le long de ses côtés longitudinaux respectifs, les racles d'essuyage (15) étant respectivement inclinées en formant un angle par rapport au plan essentiellement parallèle à la surface inférieure du réservoir (7).

**18.** Procédé selon la revendication 17, dans lequel le dispositif est soumis à un déplacement alternatif par-dessus le pochoir (2).

**19.** Procédé selon l'une quelconque des revendications 16 à 18, comprenant en outre l'étape consistant à déplacer le dispositif par-dessus une plaque non perforée (26) tout en exerçant une pression uniforme sur le produit (9) dans la cavité du réservoir (7) et avant le déplacement par-dessus le pochoir (2), de façon à obtenir un mélange du produit (9).

**20.** Procédé selon l'une quelconque des revendications 16 à 19, dans lequel le dispositif comprend en outre des premier et deuxième éléments d'étanchéisation (16) disposés aux extrémités de la racle ou de chaque racle d'essuyage (15) de façon à obtenir une étanchéisation latérale.

**21.** Procédé selon l'une quelconque des revendications 16 à 20, dans lequel le dispositif comprend en outre une grille perforée (17) disposée à l'orifice du réservoir (7), à travers laquelle est poussée la quantité en excès du produit (9).

**22.** Procédé selon la revendication 21, dans lequel le coefficient d'ouverture de la grille (17) représente entre 20 et 90 %.

**23.** Procédé selon l'une quelconque des revendications 21 à 22, dans lequel la grille (17) est amovible.

**24.** Procédé selon la revendication 23, dans lequel la grille (17) et la racle ou chaque racle d'essuyage (15) forment un assemblage amovible par rapport au réservoir (7).

**25.** Procédé selon l'une quelconque des revendications 16 à 24, dans lequel les parois internes (8) de la cavité du réservoir (7) sont orthogonales par rapport au plan essentiellement parallèle à la surface inférieure du réservoir (7).

**26.** Procédé selon la revendication 25, lorsqu'elle dépend de l'une quelconque des revendications 21 à 24, dans lequel la grille (17) et les parois internes (8) de la cavité du réservoir (7) sont orthogonales.

**27.** Procédé selon l'une quelconque des revendications 16 à 26, dans lequel le dispositif comprend en outre un réservoir intermédiaire amovible (23) qui peut venir s'insérer dans le réservoir (7).

**28.** Procédé selon la revendication 27, dans lequel la cavité est définie par le réservoir intermédiaire (23).

**29.** Procédé selon la revendication 27 ou 28, lorsqu'elle dépend de la revendication 21, dans lequel le réservoir intermédiaire (23) englobe la grille (17).

**30.** Procédé selon l'une quelconque des revendications 16 à 29, dans lequel le produit (9) est de la pâte à braser et le substrat (1) est une plaquette de circuits imprimés.

FIG. 1

FIG. 2

F2

F1   10   12

9   11

15   17

15A   15

14   A

15B

FIG. 3

F1

9

15B   15

19

FIG. 5

FIG. 4

EP 0 935 532 B1

FIG.6

FIG.7

FIG.8

FIG.9

FIG. 10

EP 0 935 532 B1

FIG.11

FIG.12

FIG. 13

EP 0 935 532 B1